# EUROPEAN PATENT APPLICATION

(11) **EP 4 766 046 A1**
(43) Date of publication of application: **24.06.2026**
(21) Application number: 25225834.8
(22) Date of filing: 19.12.2025
(51) Int. Cl.: H05K 7/14, H02B 1/00

(54) **RACK POWER DISTRIBUTION UNIT**

(30) Priority: 19.12.2024 US 202463736162 P; 19.09.2025 US 202563884432 P; 11.12.2025 US 202519416928
(71) Applicant: Vertiv Corporation, Westerville, OH 43082 (US)
(72) Inventor: FERGUSON, Kevin R., Westerville, 43082 (US); BUSH, Brian E., Westerville, 43082 (US); POTTER, Benjamin G., Westerville, 43082 (US); BERGMAN, Scott A., Westerville, 43082 (US); ALDAG, Philip R., Westerville, 43082 (US)
(74) Representative: Bryn-Jacobsen, Caelia

(57) **Abstract**

A rack power distribution unit (rPDU) system may include a chassis formed of a plurality of faces that define a cavity. The plurality of faces may include a front face including two or more tiers. The two or more tiers may include a first tier positioned proximate to a second tier. The rPDU system may include one or more over current protection devices (OCPDs) coupled to the two or more tiers. The one or more OCPDs may include a first set of OCPDs coupled to the first tier and a second set of OCPDs coupled to the second tier, where the first set is arranged at an offset relative to the second set.

## Description

### CROSS-REFERENCE TO RELATED APPLICATIONS

The present applications claims the benefit under 35 U.S.C. § 119(e) of U.S. Provisional Application No. 63/736,162, filed December 19, 2024, and U.S. Provisional Application No. 63/884,432, filed September 19, 2025.

### TECHNICAL FIELD

The present disclosure generally relates to the field of power distribution systems, and more particularly, to a wedge shaped rack power distribution unit with improved convective airflow.

### BACKGROUND

As high-performance computing (HPC) and artificial intelligence (AI) drive data center operations to environmental and utilization limits, the need for improved power distribution systems increases. Horizontally mounted rack power distribution units (rPDUs) often support the high-power demands of power supply units (PSUs) within or coupled to computer servers used for HPC/AI workload processing. Over current protection devices (OCPDs) are often used as a safety feature to protect systems from over currents (e.g., short circuit, ground faults, current overloads, and the like). Due to the high current demands of HPC/AI workloads, OCPDs are required to operate continuously near or at a nameplate current rating. However, there are space-constraints to accommodate the mounting of numerous OCPDs along the faces of the rPDUs, along with the numerous power distribution outlets, large power input ports and termination, and other ancillary components. Conventional horizontally mounted systems include stacked two-dimensional OCPD array mounting configurations, however such systems restrict convective airflow which can lead to overheating of the OCPDs. For example, since hot air rises, the OCPDs located near the top of the rack frame may overheat from the mutual heating exacerbated by the stacked mounting.

As such, there is a need for a horizontally mounted rack power distribution unit with improved convective airflow.

### SUMMARY

A rack power distribution unit is disclosed, in accordance with one or more examples of the present disclosure. In examples, the rack power distribution unit includes: a chassis formed of a plurality of faces that define a cavity, the plurality of faces including at least a front face, a rear face, one or more side faces, a top face, and a bottom face, where the front face includes two or more tiers including at least a first tier positioned proximate to a second tier; and one or more over current protection devices coupled to the two or more tiers, where the one or more over current protection devices includes at least a first set of the one or more over current protection devices coupled to the first tier and a second set of the one or more over current protection devices coupled to the second tier, where the first set of the one or more over current protection devices are arranged at an offset relative to the second set of the one or more over current protection devices.

A rack power distribution unit is disclosed, in accordance with one or more examples of the present disclosure. In examples, the rack power distribution unit includes: a chassis formed of a plurality of faces that define a cavity, the plurality of faces including at least a front face, a rear face, one or more side faces, a top face, and a bottom face, where the front face includes two or more tiers including at least a first tier positioned proximate to a second tier; and one or more over current protection devices coupled to the two or more tiers, where the one or more over current protection devices includes at least a first set of the one or more over current protection devices coupled to the first tier and a second set of the one or more over current protection devices coupled to the second tier.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The detailed description is described with reference to the accompanying figures. The use of the same reference numbers in different instances in the description and the figures may indicate similar or identical items. Various examples or examples ("examples") of the disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1A illustrates a perspective view of a rack power distribution unit, in accordance with one or more examples of the present disclosure.
FIG. 1B illustrates a perspective view of the rack power distribution unit, in accordance with one or more examples of the present disclosure.
FIG. 2A illustrates a front perspective view of the rack power distribution unit, in accordance with one or more examples of the present disclosure.
FIG. 2B illustrates a side perspective view of the rack power distribution unit, in accordance with one or more examples of the present disclosure.
FIG. 2C illustrates a side perspective view of the rack power distribution unit, in accordance with one or more examples of the present disclosure.
FIG. 3A illustrates a perspective view of a cavity of the rack power distribution unit including one or more over current protection devices, in accordance with one or more examples of the present disclosure.
FIG. 3B illustrates a perspective view of a cavity of the rack power distribution unit including one or more over current protection devices, in accordance with one or more examples of the present disclosure.
FIG. 4A illustrates a side perspective view of the rack power distribution unit, in accordance with one or more examples of the present disclosure.
FIG. 4B illustrates a rear perspective view of the rack power distribution unit, in accordance with one or more examples of the present disclosure.
FIG. 4C illustrates a front view of the rack power distribution unit, in accordance with one or more examples of the present disclosure.
FIG. 4D illustrates a side view of the rack power distribution unit, in accordance with one or more examples of the present disclosure.
FIG. 4E illustrates a top view of the rack power distribution unit, in accordance with one or more examples of the present disclosure.
FIG. 4F illustrates a bottom view of the rack power distribution unit, in accordance with one or more examples of the present disclosure.
FIG. 5A illustrates a side perspective view of the rack power distribution unit, in accordance with one or more examples of the present disclosure.
FIG. 5B illustrates a front view of the rack power distribution unit, in accordance with one or more examples of the present disclosure.
FIG. 5C illustrates a side view of the rack power distribution unit, in accordance with one or more examples of the present disclosure.
FIG. 5D illustrates a top view of the rack power distribution unit, in accordance with one or more examples of the present disclosure.
FIG. 5E illustrates a bottom view of the rack power distribution unit, in accordance with one or more examples of the present disclosure.
FIG. 6A illustrates a bottom perspective view of the rack power distribution unit installed in a rack, in accordance with one or more examples of the present disclosure.
FIG. 6B illustrates a perspective view of the rack power distribution unit installed in a rack, in accordance with one or more examples of the present disclosure.
FIG. 6C illustrates a bottom perspective view of the rack power distribution unit installed in a rack, in accordance with one or more examples of the present disclosure.
FIG. 7A illustrates a rear perspective view of the rack power distribution unit, in accordance with one or more examples of the present disclosure.
FIG. 7B illustrates a front view of the rack power distribution unit, in accordance with one or more examples of the present disclosure.
FIG. 7C illustrates a side view of the rack power distribution unit, in accordance with one or more examples of the present disclosure.
FIG. 7D illustrates a top view of the rack power distribution unit, in accordance with one or more examples of the present disclosure.
FIG. 7E illustrates a bottom view of the rack power distribution unit, in accordance with one or more examples of the present disclosure.
FIG. 8 illustrates a side view of the rack power distribution unit, in accordance with one or more examples of the present disclosure.

### DETAILED DESCRIPTION

Reference will now be made in detail to the subject matter disclosed, which is illustrated in the accompanying drawings.

As high-performance computing (HPC) and artificial intelligence (AI) drive data center operations to environmental and utilization limits, the need for improved power distribution systems increases. Horizontally mounted rack power distribution units (rPDUs) often support the high-power demands of power supply units (PSUs) within or coupled to computer servers used for HPC/AI workload processing. For example, rPDUs may provide power to information technology (IT) equipment and computer processing unit (CPU)/graphic processing unit (GPU) servers directly or indirectly via Open Compute Power (OCP) Open Rack (OR) compliant power shelves.

Over current protection devices (OCPDs) are often used as a safety feature to protect systems from over currents (e.g., short circuit, ground faults, current overloads, and the like). Due to the high current demands of HPC/AI workloads, OCPDs are required to operate continuously near or at a nameplate current rating (i.e., maximum current that the PDU is designed to handle under normal operating conditions). As such, for long-term reliable operation of the rPDU, the internal case temperature of the OCPD must be below or at the recommended limit and also the loading capacity of the OCPD must be less than nameplate current rating to avoid nuisance tripping and unexpected power downing of the load.

Further, as HPC/AI densification increases, the back of the rack space will become more space constrained. For example, there are space-constraints to accommodate the mounting of numerous OCPDs along the faces of the rPDUs, along with the numerous power distribution outlets, large power input ports and termination, and other ancillary components. For example, for horizontally mounted enclosures installed within the rack frame, it is difficult to accommodate the mounting of multiple OCPDs (e.g., hydraulic or thermo-magnetic circuit breakers, thermal fuses, or the like) along the front and/or rear faces.

Conventional horizontally mounted systems include stacked two-dimensional OCPD array mounting configurations with flat faced rPDUs. Such systems restrict convective airflow which can lead to overheating of the OCPDs. For example, since hot air rises, the OCPDs located near the top of the rack frame may overheat from the mutual heating exacerbated by the stacked mounting.

Accordingly, the present disclosure is directed to a rack power distribution unit (rPDU) with improved convective airflow. More particularly, the present disclosure is directed to a rPDU system including a chassis with a ventilated stepped pyramidal tiered face to allow the OCPDs to be mounted in a staggered, offset position, thereby improving convective airflow circulation around the OCPDs. As such, the temperature rise is reduced to provide more reliable operation of the OCPDs.

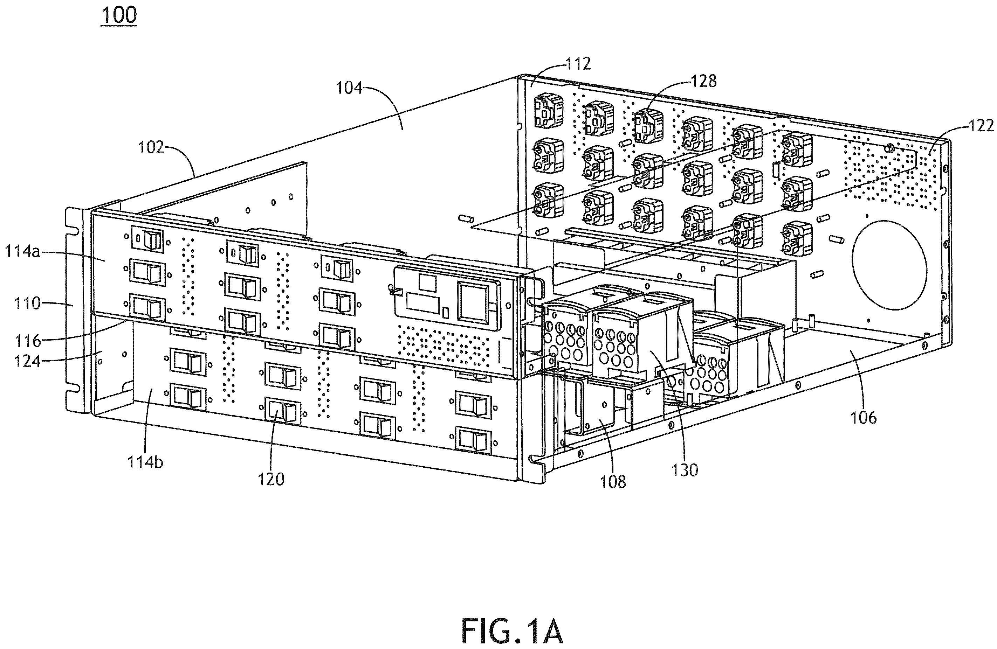

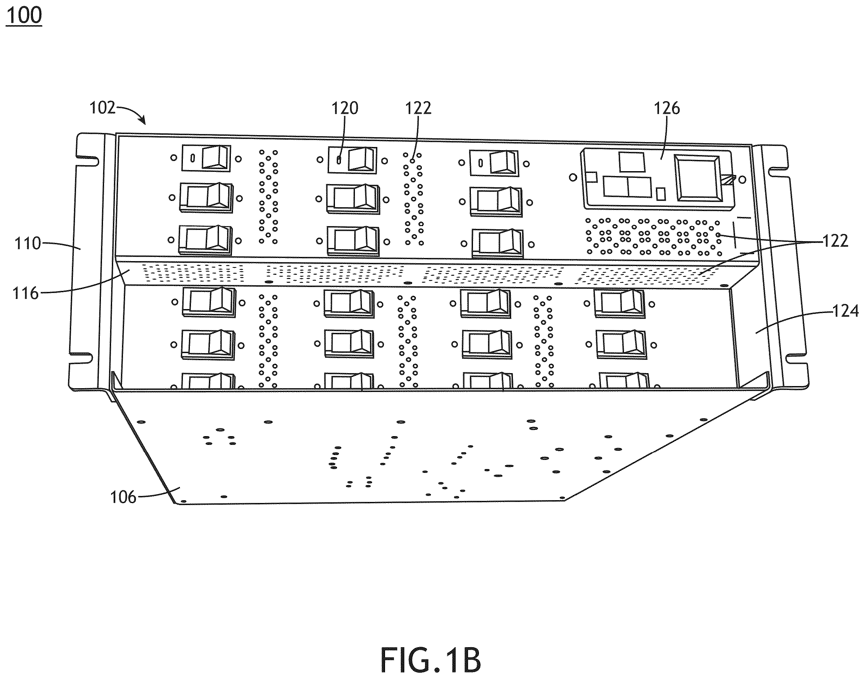

Referring to FIGS. 1A-8, a horizontally mounted rack power distribution unit (rPDU) system 100 of the present disclosure is shown. For purposes of the present disclosure, the term "rPDU", "rack PDU", "rack power distribution unit system", "horizontally mounted rack power distribution unit system", "horizontally mounted rPDU system", "system", and variations thereof may be considered equivalent, unless otherwise noted herein.

The rPDU system 100 includes a chassis 102 (or housing). The chassis 102 may be formed of any suitable material such as, but not limited to, metal, metal alloys, thermoplastics, composite materials, or the like.

The chassis 102 may be formed of a plurality of faces that define a cavity. For example, the chassis 102 may be formed of at least a top face 104, a bottom face 106, one or more side faces 108, a front face 110, and a rear face 112.

In some instances, the chassis 102 may be substantially rectangular. For example, as shown in FIGS. 1A-6B, the top face 104 may have a flat, planar surface, where the front and back of the chassis 102 may have a similar elevation. For instance, the chassis 102 may be constructed with parallel top and bottom faces 104, 106, where the side faces 108 may be perpendicular to both, forming a box-like enclosure. Such configuration provides a uniform internal cavity, which can facilitate straightforward component layout and wiring within the unit. The flat top face 104 allows for easy stacking or placement of additional equipment above the rPDU system 100, enhancing the use of vertical rack space.

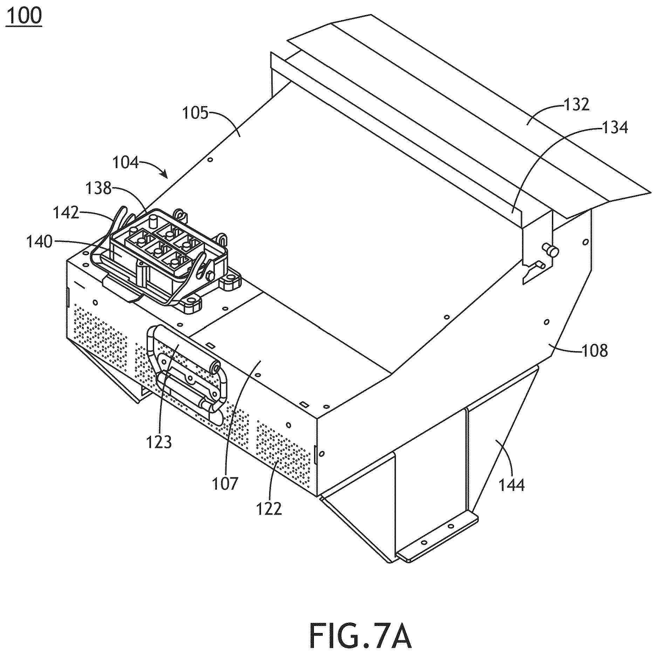

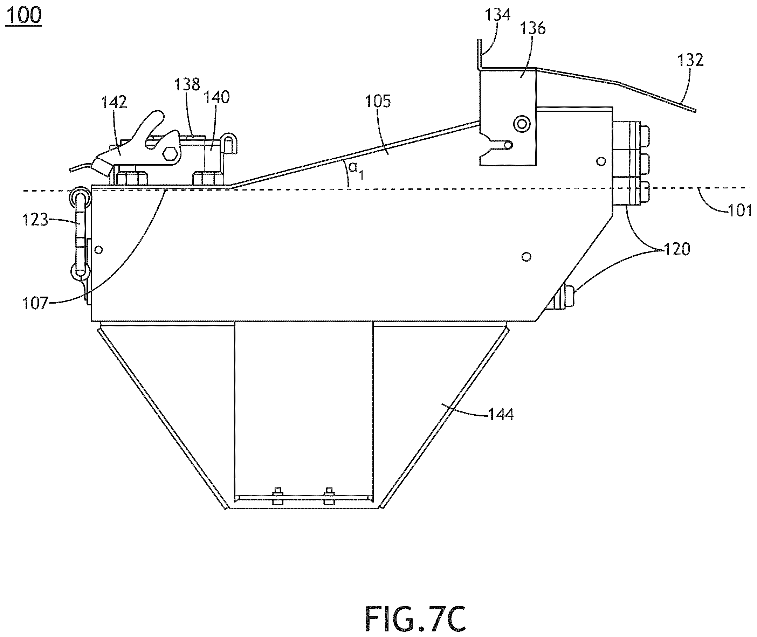

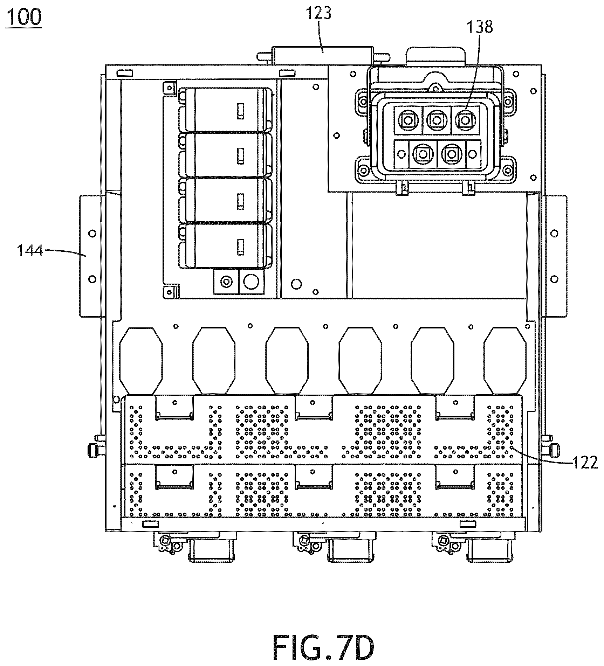

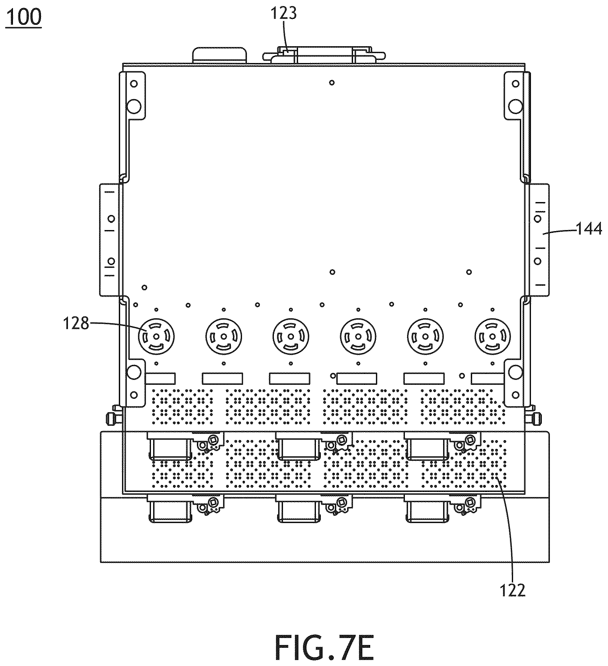

In some instances, the chassis 102 may have a wedge shape. For example, as shown in FIGS. 7A-7E, at least a portion of the top face 104 may have an angled (or tilted) surface arranged on an inclined plane. For instance, a portion 105 the top face 104 may be arranged at an angle α₁ with respect to an axis 101 perpendicular to the rear face 112 of the chassis 102. Further, a second portion 107 of the top face 104 may be arranged flat, such that the second portion 107 is perpendicular to the rear face 112 of the chassis 102. In this regard, the front and back of the chassis 102 have different elevations, where the front is at a higher elevation than the back of the chassis 102. It is contemplated herein that the wedge shape of the chassis 102 may provide a number of benefits including, but not limited to, reduced weight, easier assembly (e.g., shorter wall height near the back improves the access during internal wiring of the unit), improved airflow/thermal performance, improved installation fit, and improved aesthetic design.

The angle α₁ of the portion 105 of the top face 104 may be between 10-15 degrees. For example, the angle α₁ of the portion 105 of the top face 104 may be 10 degrees. It is noted that the angle α₁ should be configured such that the design for manufacturability is not negatively impacted due to a reduced volume at the shallow end (e.g., rear/back end of the chassis 102), which may cause challenges for terminating wire from input connector to terminal block w/o compromising bend radius.

Although FIGS. 7A-7E depict the top face 104 including two portions 105, 107 having different angles, it is contemplated herein that the top face 104 may include a single portion arranged at the angle α₁. Further, the angle α₁ shown in FIGS. 7A-7E shall not be construed as limiting. Rather, FIGS. 7A-7E are provided merely for illustrative purposes.

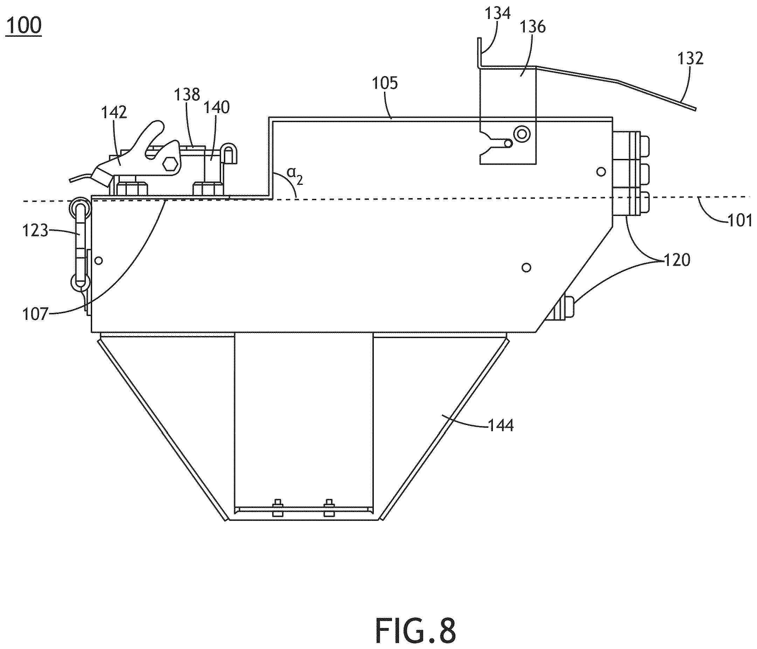

Additionally, in some examples, as shown in FIG. 8, the top face 104 may be stepped. For example, the first portion 105 may be arranged perpendicular to the second portion. For instance, the first portion 105 may be arranged at an angle α₂ from the second portion 107, where the angle α₂ is approximately 90-degrees. It is contemplated herein that although FIG. 8 depicts the chassis 102 including a single stepped portion (e.g., portion 107), the chassis 102 may include any number of stepped portions arranged at approximately 90-degrees from a respective portion.

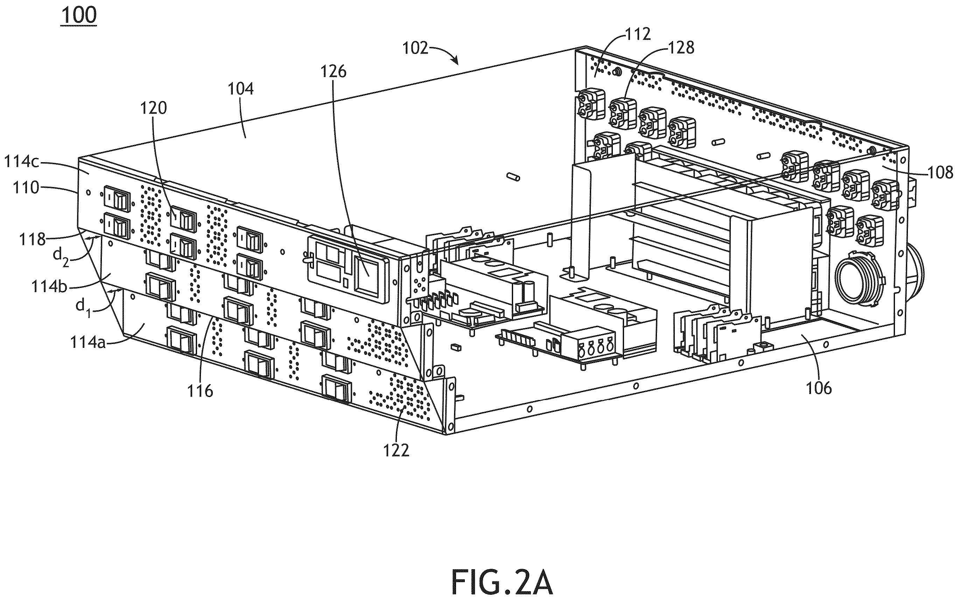

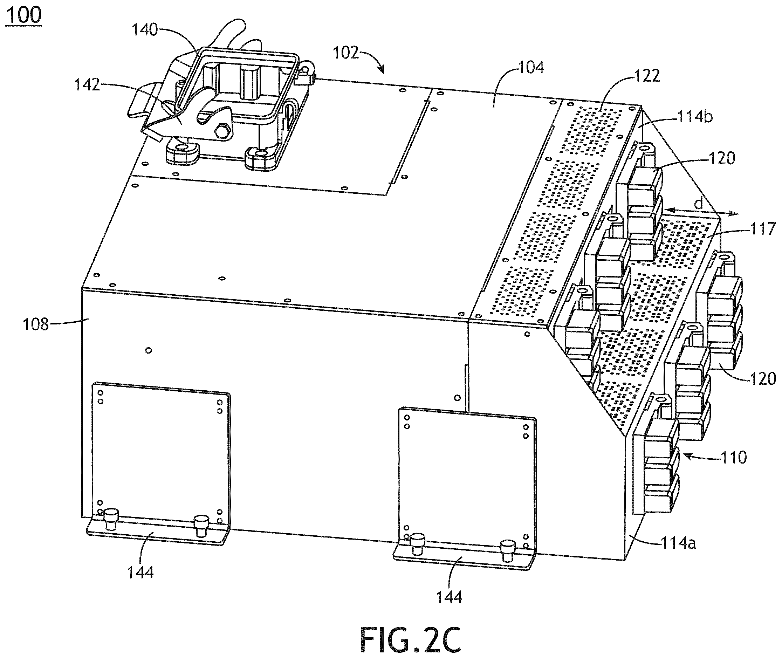

The front face 110 includes a tiered face formed of two or more tiers. For example, as shown in FIGS. 1A-2B, a bottom flange of a respective tier may protrude substantially perpendicular at approximately a 90-degree edge towards the interior of the chassis 102. By way of another example, as shown in FIG. 2C, a top flange of a respective tier may protrude substantially perpendicular at approximately a 90-degree edge towards the interior of the chassis 102.

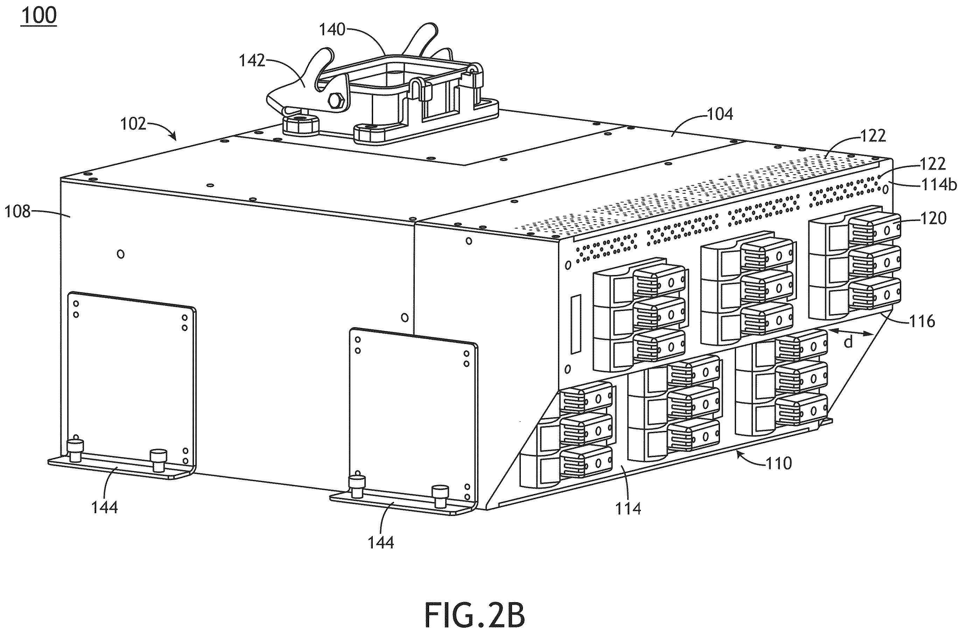

Referring to FIGS. 1A-1B and 2B-2C, the front face 110 may include a two-tiered face 114 formed of a first tier 114a and a second tier 114b. In this example, the first tier 114a may be a bottom tier and the second tier 114b may be a top tier. In one instance, as shown in FIGS. 1A-1B and 2B, a bottom flange 116 of the second tier 114b (or top tier) may protrude a select distance d above (or over) the first tier 114a (or bottom tier). In another instance, as shown in FIG. 2C, a top flange 117 of the first tier 114a (or bottom tier) may protrude a select distance d past a front surface the second tier 114b (or top tier).

By way of another example, as shown in FIG. 2A, the front face 110 may include a three-tiered face formed of a first tier 114a, a second tier 114b, and a third tier 114c. In this example, the first tier 114a may be a bottom tier, the second tier 114b may be a middle tier, and the third tier 114c may be a top tier, where a bottom flange 116 of the second tier 114b (or middle tier) protrudes a select distance d₁ above (or over) the first tier 114a (or bottom tier) and a bottom flange 118 of the third tier 114c (or top tier) protrudes a select distance d₂ above (or over) the second tier 114b (or middle tier) and the first tier 114a (or bottom tier).

The two or more tiers 114a-114c may be configured to couple to at least one of one or more portions of the one or more faces of the chassis 102 or one or more portions of respective tiers positioned proximate to the respective tier via one or more fasteners (e.g., threaded studs, nuts, or the like). For example, in a non-limiting example, as shown in FIGS. 1A-1B, the first tier 114a (or bottom tier) may be configured to couple to at least the bottom face 106 of the chassis 102 via the one or more fasteners. Continuing with the above example, the second tier 114b (or top tier) may be configured to couple a portion of the first tier 114a (or bottom tier) via the one or more fasteners. In some examples, the second tier 114b (or top tier) may be configured to couple to a portion of the top face 104 of the chassis 102 via the one or more fasteners. By way of another example, in a non-limiting example, as shown in FIG. 2A, the first tier 114a (or bottom tier) may be configured to couple to at least the bottom face 106 of the chassis 102 via the one or more fasteners. Continuing with the above example, the second tier 114b (or middle tier) may be configured to couple a portion of the first tier 114a (or bottom tier) via the one or more fasteners and the third tier 114c (or top tier) may be configured to couple to a portion the second tier 114b (or middle tier) via the one or more fasteners.

In some examples, as shown in FIGS. 2B-2C, the two or more tiers 114a-114c may be a single, integrated component configured to be coupled to the one or more faces of the chassis 102 via one or more fasteners. For example, as shown in FIGS. 2B-2C, the first tier 114a and the second tier 114b may be formed as a single, integrated component, where said component may couple to the one or more faces of the chassis 102.

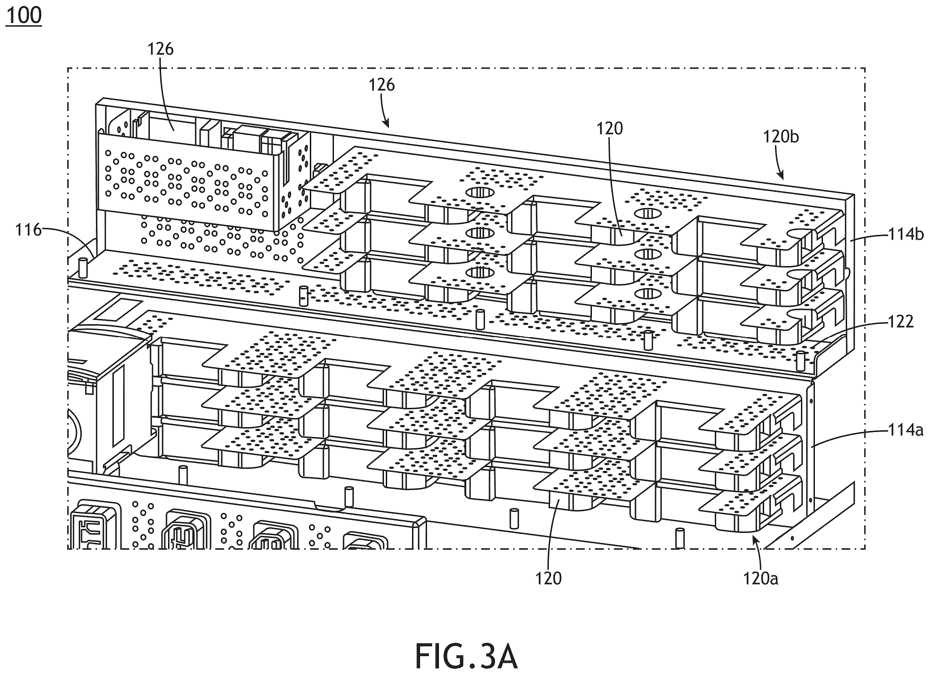

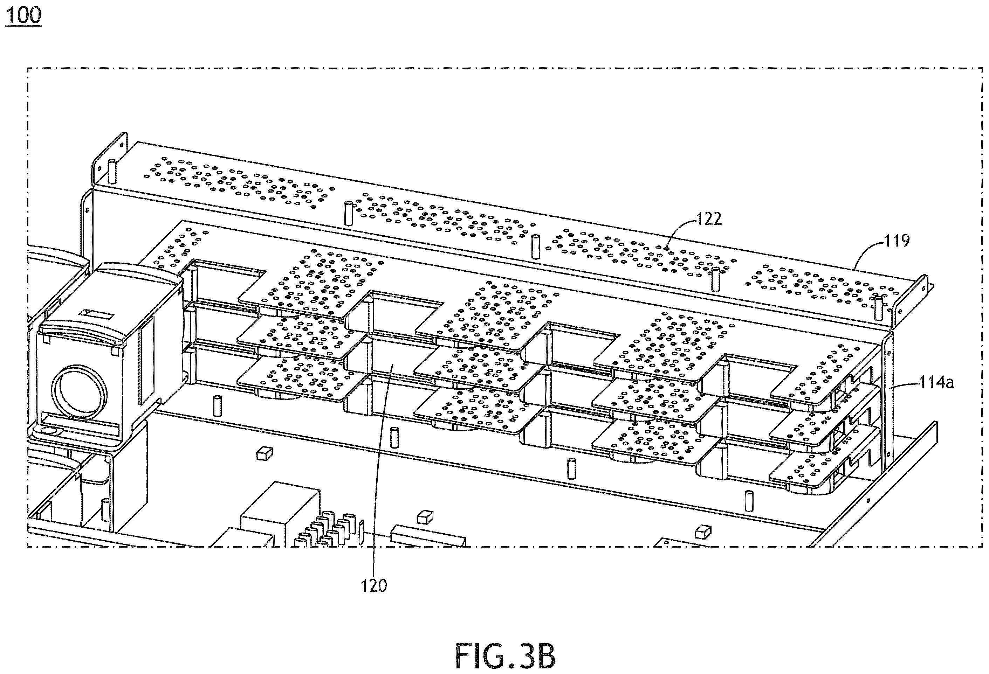

Referring to FIGS. 3A and 3B, the bottom flange 116, 118 of the tiers 114a-114c may include one or more through holes configured to receive the one or more fasteners. For example, the tiers 114a-114c may include a top flange 119 that extends substantially perpendicular at approximately a 90-degree edge toward the exterior the chassis 102, where the top flange 116 includes the one or more fasteners (e.g., threaded studs). In this regard, as shown in FIGS. 3A and 3B, the bottom flange 116 of the second tier 114b (or top tier) may be configured to couple to the top flange 119 of the first tier 114a (or bottom tier) via the one or more through holes and the one or more fasteners.

It is contemplated herein that with the bottom flanges 116, 118 exposing the OCPDs 120 to the exterior of the rPDU, the bottom flanges 116, 118 may provide a bottom surface for perforated ventilation pattern that is compliant with the UL finger probe test and provide air flow. In a non-limiting example, the tiers 114a-114c may have small 0.500" 90° edge bends on each side that are form threaded to 6/32" to attach to the lid with tamper proof closure screws. Continuing with the above non-limiting example, the very top tier top edge bend may also have a 0.500" 90° edge bend with form threaded to 6/32" to attach to the lid with tamper proof closure screws.

It is contemplated herein that this method of fabrication may be easier to assemble in production, and more robust than traditional self-tapping closure screws. Further, the PEM studs and nuts (or other fasteners) may also be used for ground bounding for that respective tier instead of a ground bound strap, thereby eliminating the need for extra heavy gauge wire clutter.

Although FIGS. 1A-1B and FIG. 2A-2C depict the rPDU system 100 including a two-tier face 110 and a three-tier face 110, respectively, it is contemplated herein that the rPDU system 100 may include any number and configuration of tiered faces 110.

The front face 110 may couple to (or include) one or more over current protection devices (OCPDs) 120. For example, each tier 114a-114c may include a set of one or more OCPDs 120. The arrangement of the two or more tiers 114a-114c of the front face 110 may allow the OCPDs 120 to be mounted in a staggered, offset configuration, thereby reducing mutual temperature rise of their proximate surfaces along the columns. For example, as shown in FIG. 3A, the one or more OCPDs 120 may include at least a first set 120a of the one or more OCPDs 120 arranged on the first tier 114a and a second set 120b of the one or more OCPDs 120 arranged on the second tier 114b, where the individual OCPDs within the sets 120a, 120b may be offset relative to the OCPDs of the respective OCPDs. For instance, in a non-limiting example, as shown in FIG. 3A, the first set 120a of OCPDs may include four columns of three OCPDs 120 on the first tier 114a and the second set 120b of OCPDs may include three columns of three OCPDs 120 on the second tier 114b, where the respective columns of OCPDs on the first tier 114a are offset a select distance from the respective columns of OCPDs on the second tier 114b such that the respective OCPDs from the tiers are staggered and not in physical contact with each other. It is contemplated herein that the OCPDs have characteristic localized Joule heating, i.e., hot spot, nearer the interior terminals side. Therefore, the tier's depth may be at least projected outward 50% relative to the depth dimension of the OCPD mounted on tier below, such that the hot spots are unaligned.

It is contemplated here that the ventilated stepped pyramidal tiered face(s) allow for directed ingress of outside air to maintain steady convective air flow and heat transfer around the OCPD to reduce temperature rise and mitigate potential for nuisance tripping. In examples, the inverted pyramidal tiered steps depicted in the figures facilitate a more efficient shape (e.g., hood) to capture the cooler supply air forced upwards through a raised floor, e.g., from a hot aisle containment (HAC) system.

Although FIGS. 1A-3B depict the OCPDs 120 in a specific configuration/layout whereby the OCPDs are staggered linearly between the respective tiers, it is contemplated herein that the OCPDs 120 may be arranged in any configuration on the chassis 102 suitable for offsetting the respective OCPDs 120.

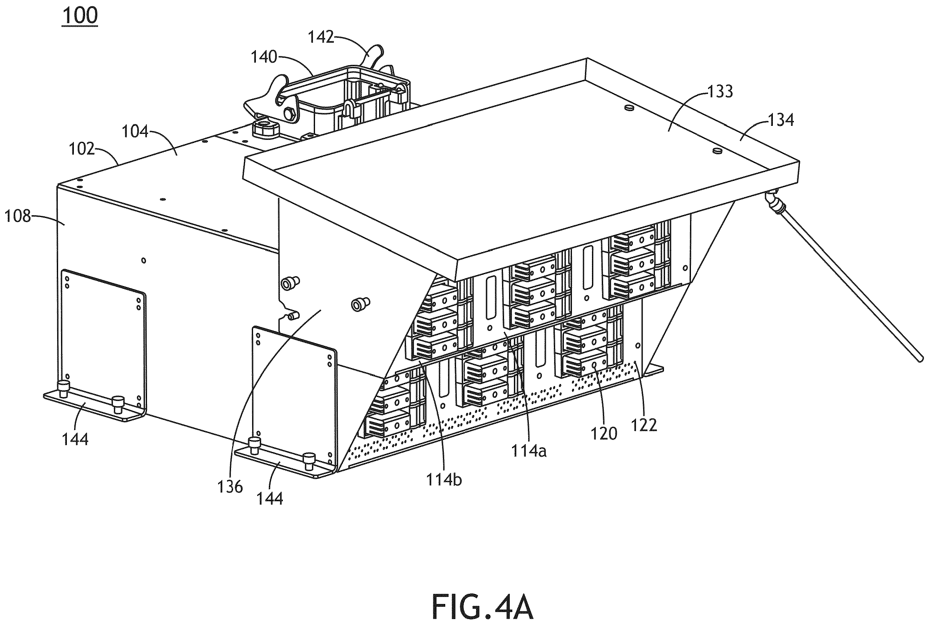

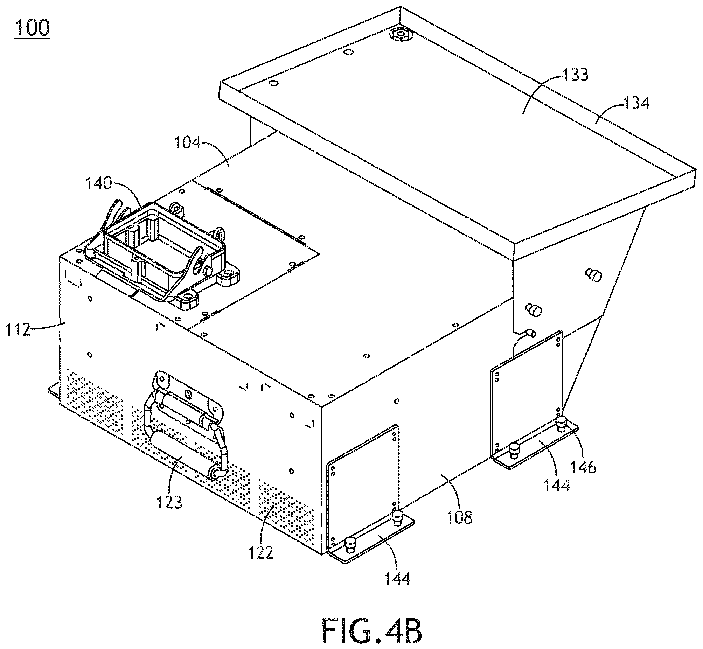

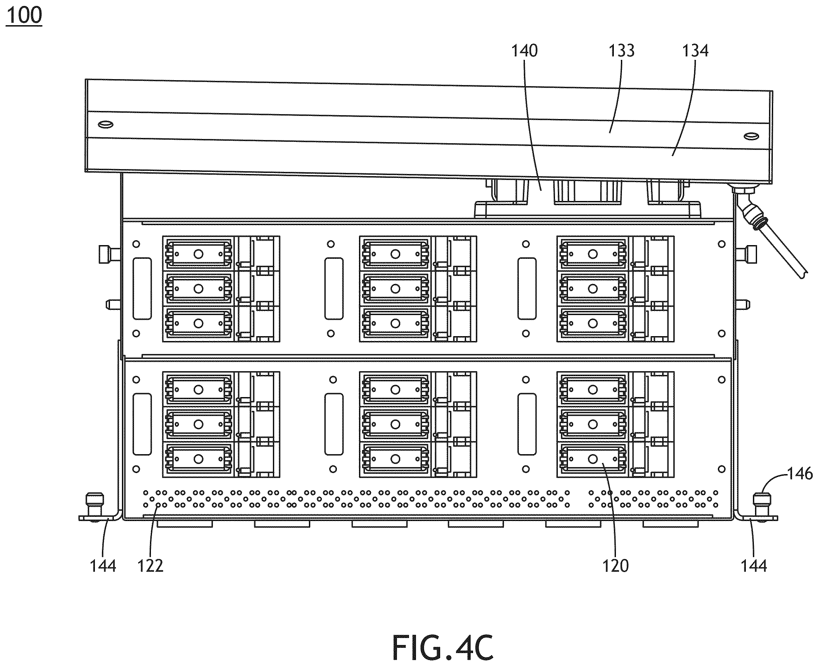

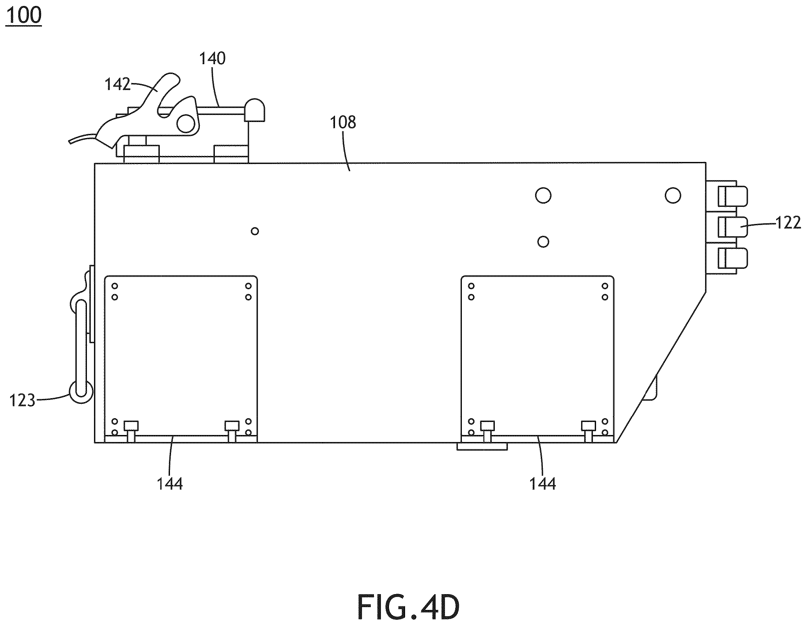

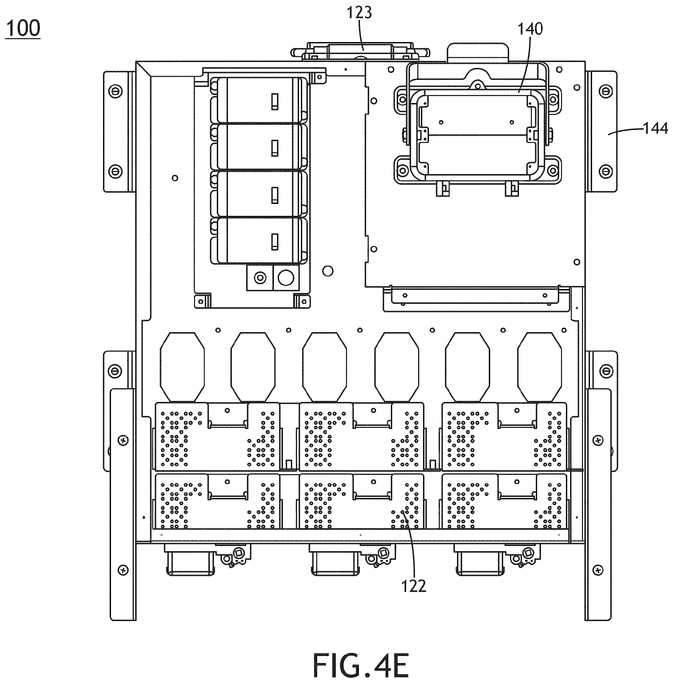

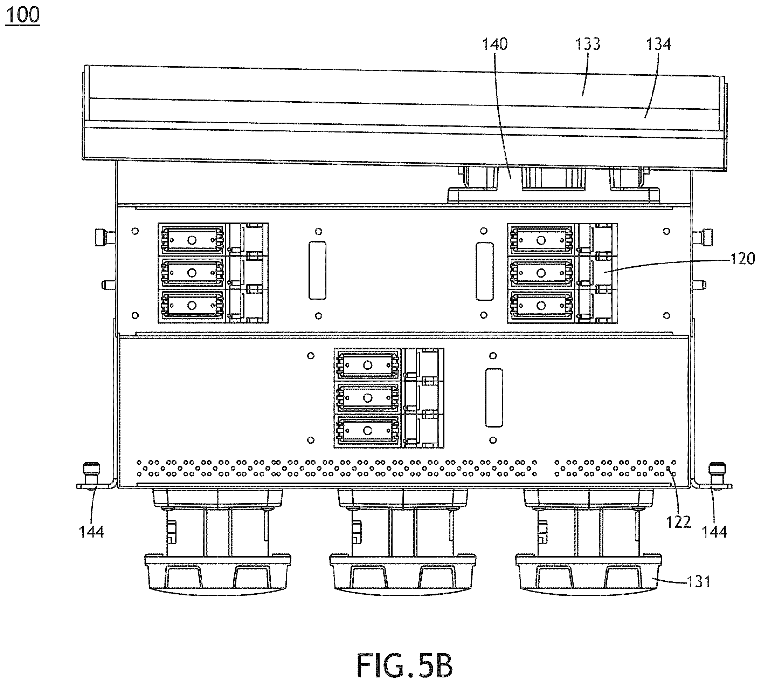

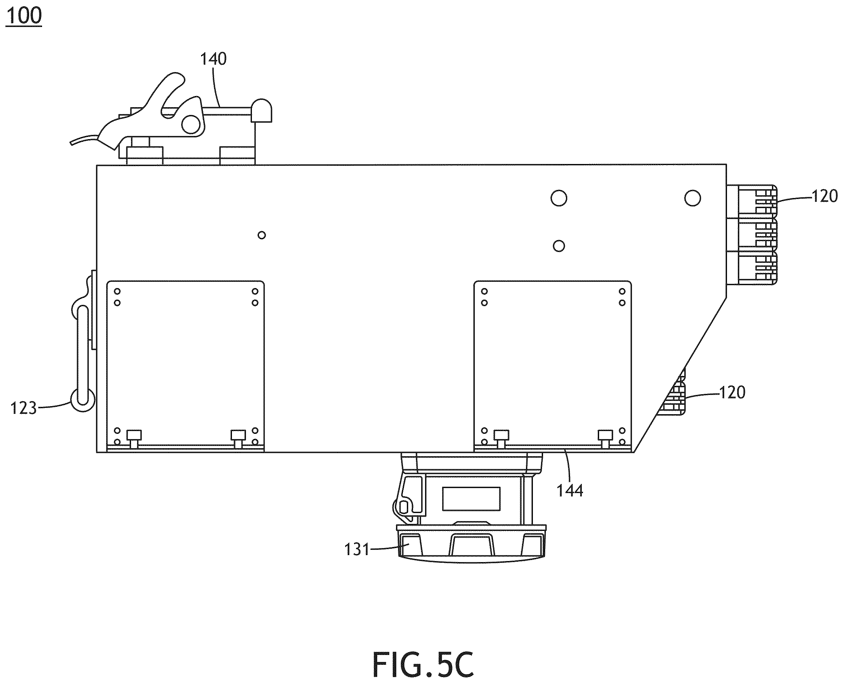

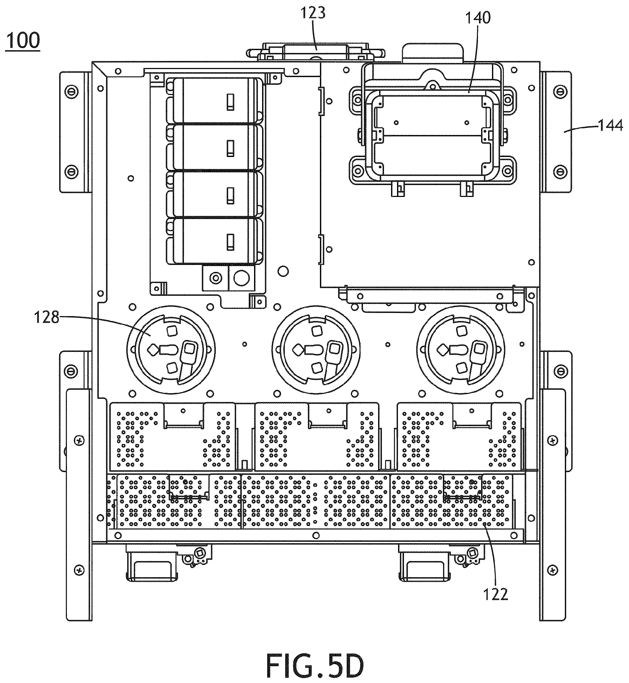

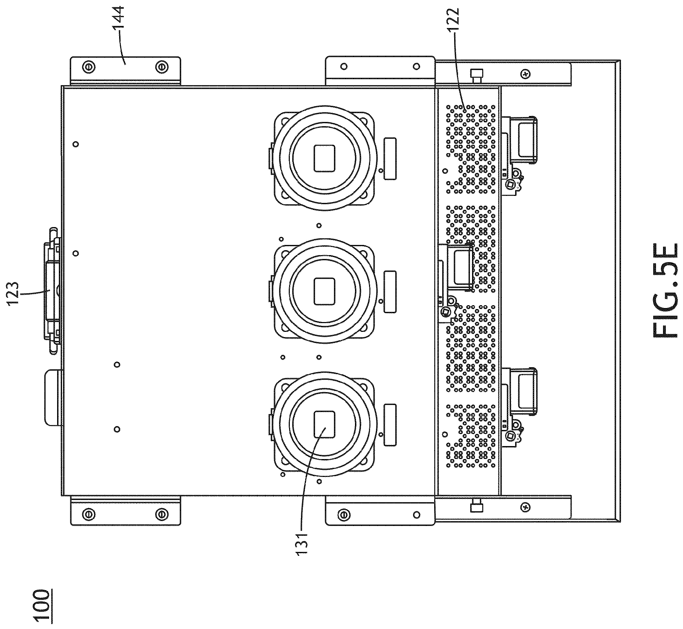

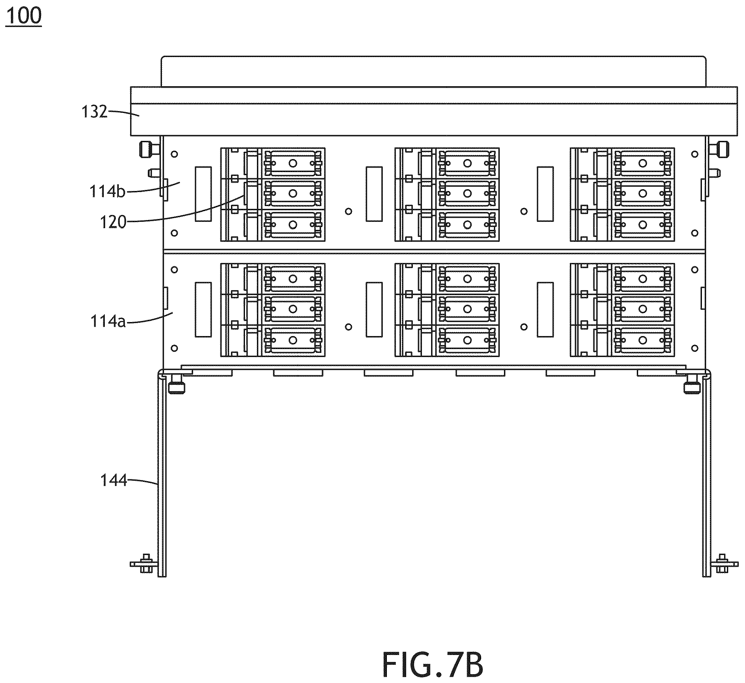

The OCPDs 120 may include any type of OCPD including, but not limited to, one or more circuit breakers (e.g., hydraulic circuit breakers, thermo-magnetic circuit breakers, or the like), one or more fuses (e.g., thermal fuses), or the like. For example, in a non-limiting example, the one or more OCPDs 120 may include one or more fusible disconnect switches, where the one or more fusible disconnect switches provide overcurrent protection and selective shutdown. For example, as shown in FIGS. 4A and 4C and FIG. 7B, the front face 110 may include 6 x 3^{®} 30A fusible disconnect switches. By way of another example, as shown in FIG. 5B, 4C, the front face 110 may include 3 x 3Φ 60A fusible disconnect switches.

The tiers 114a-114c may include one or more ventilation holes 122 to provide additional ventilation free-air space and enhanced airpaths for improved natural and forced convective airflow. For example, the bottom flanges 116, 118 may include one or more ventilation holes 122. By way of another example, a front surface of the tiers 114a-114c may include one or more ventilation holes 122. By way of another example, the top flange 117 may include one or more ventilation holes 122. Although FIGS. 1A-8 depict a specific arrangement of ventilation holes 122, it is contemplated herein that the rPDU system 100 may include any configuration/arrangement of ventilation holes 122 suitable for providing additional ventilation free-air space and improved forced convective airflow.

The rear face 112 may further include the one or more ventilation holes 122.
- Referring to FIGS. 1A-1B, the rPDU system 100 may include one or more air blocking covers 124 configured to limit by-pass airflow.

The rPDU system 100 may include one or more web cards 126. For example, the one or more web cards 126 may be positioned a select distance from the OCPDs 120 on at least one tier of the tiers 114a-114c. In this regard, any heat generated from the OCPDs 120 may be separated from the one or more web cards 126 to minimize the web cards 126 from shutting down due to excessive MPU die temperature, and vice versa.

Referring to FIG. 1A, the rear face 112 may couple to one or more receptacles 128. For example, the rear face 112 may include one or more female receptacles 128 configured to receive one or more male plugs. For instance, the rear face 112 of the chassis 102 may include one or more C19 outlets in compliance with IEC60320 standards and configured to receive one or more C20 plugs. Although FIG. 1A depicts the rPDU system 100 including a specific number and arrangement of C19 outlets, it is noted herein that the rPDU system 100 may include any number of outlets and any type of outlet.

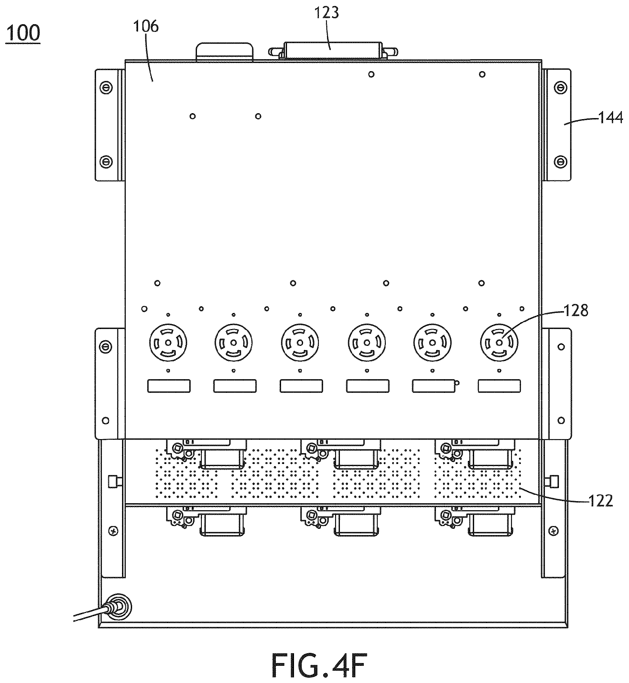

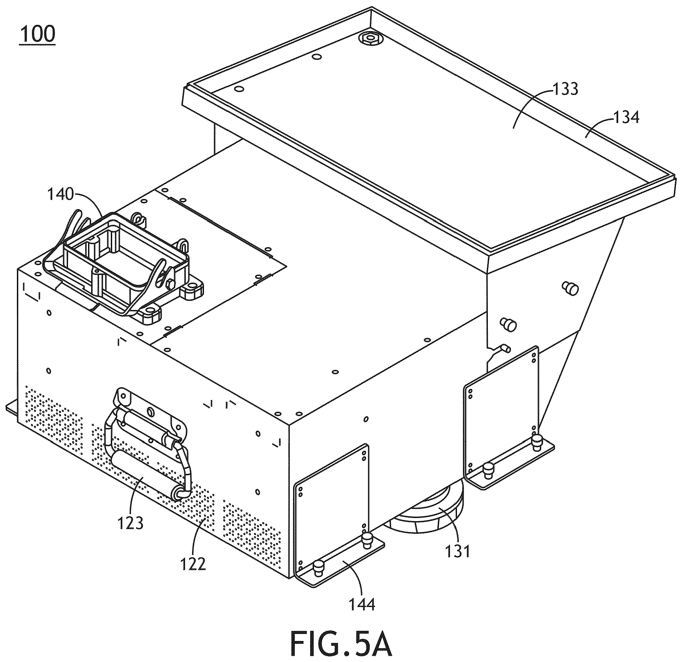

Referring generally to FIGS. 4F, 5D, 6A, 6C, 7E, the bottom face 106 may couple to one or more receptacles 128. For example, as shown in FIGS. 4F, 6A-6C, 7E, the bottom face 106 may include one or more National Electrical Manufacturers Association (NEMA) receptacles 128 configured to receive one or more NEMA plugs 129. For instance, the bottom face 106 may include six NEMA receptacles 128 configured to receive six NEMA plugs 129. By way of another example, as shown in FIGS. 5A-5E, the bottom face 106 may include one or more International Electrotechnical Commission (IEC) receptacles 128 configured to receive one or more IEC plugs 131. For instance, the bottom face 106 may include three IEC receptacles 129 configured to receive three IEC plugs 131. It is contemplated herein that it is arranging the receptacles 128 on the bottom of the chassis 102 may be desirable for applications where the rPDU system 100 is mounted in an intermediate position outside the rack. As such, it may be desirable to drop the load side cables (LSCs) downward rather than inline to facilitate more efficient routing of the LSCs to the devices receiving power within the rack. Although the figures depicts the rPDU system 100 including a specific number and arrangement of NEMA/IEC receptacles, it is noted herein that the rPDU system 100 may include any number and/or type of receptacles. For example, where it is desirable to route the cables inline, the receptacles 128 may be arranged on a backside of the chassis 102.

The rPDU system 100 may include one or more power inlets 138. For example, as shown in FIGS. 4A-4E, 5A-5D, 7A, 7C, 7D, 8, the top face 104 of the chassis 102 may include one or more bulkhead connectors 140 configured to receive (or couple to) the one or more power inlets 138. The power inlets 138 may be configured to removably attach to one or more detachable power distribution whips (e.g., facility side cable (FSC) whips, or the like). In some instances, the top face 104 may further include one or more cable cleats 142 to secure cables/whips to the chassis 102.

The rPDU system 100 may include one or more handles 123. For example, the rear face 112 may include one or more handles 123. By way of another example, one of the side faces 108 may include one or more handles 123. It is contemplated herein that the handle 123 of the rPDU system 100 may be arranged on any portion of the chassis 102 without departing from the scope of the present disclosure.

The rPDU system 100 may include one or more distribution blocks 130. For example, the cavity of the chassis 102 may house the one or more distribution blocks 130. The one or more distribution blocks 130 may couple to the one or more OCPDs 120, and other components/equipment of the rPDU system 100.

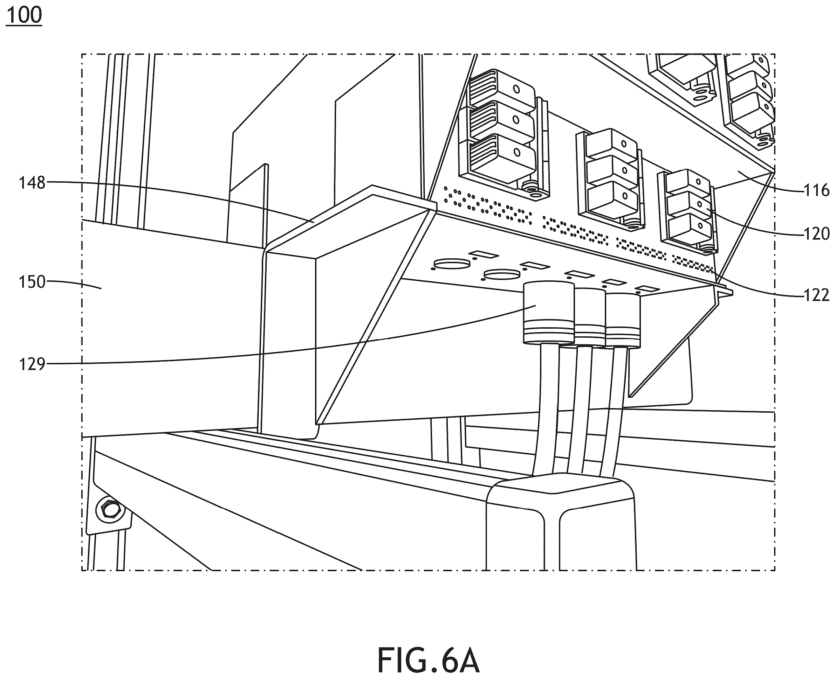

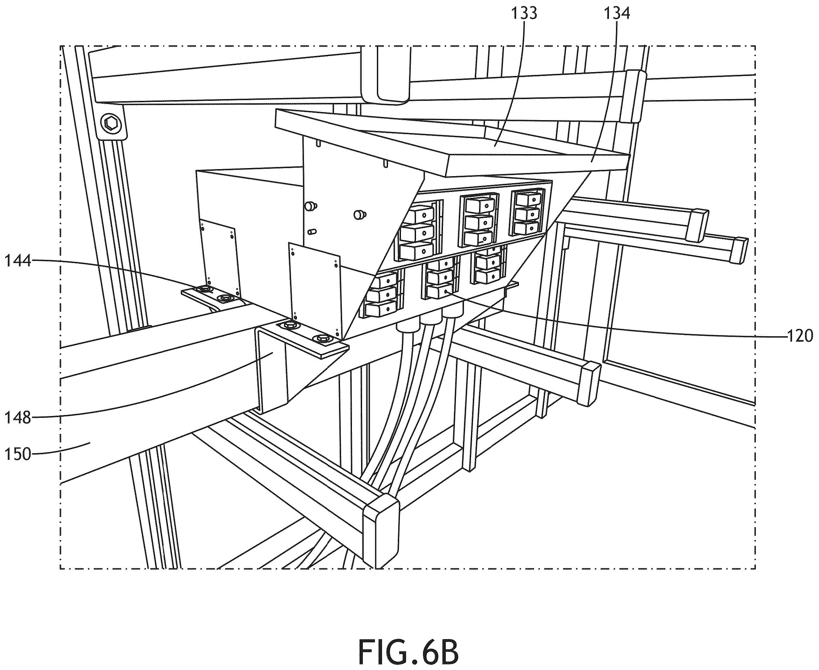

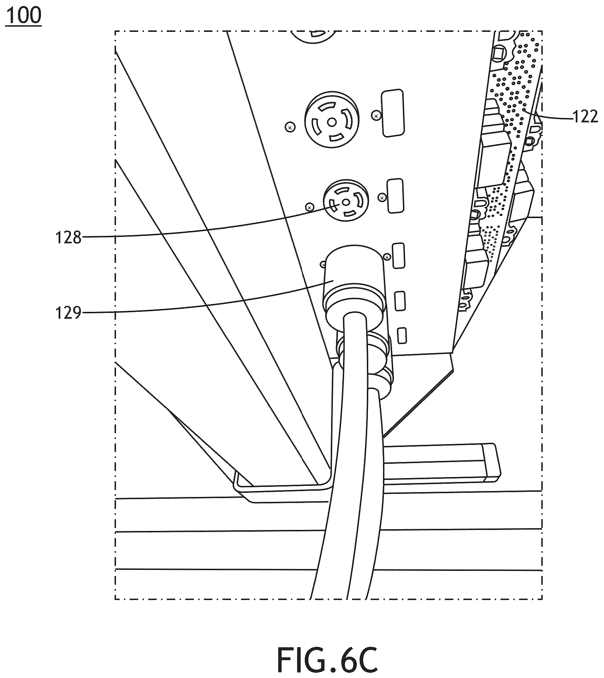

Referring to FIGS. 4A-4C, 5A-5B, and 6A-6B, the rPDU system 100 may include a drip pan 133. For example, the drip pan 133 may be arranged above the top face 104 of the chassis 102 and include one or more raised edges 134. The drip pan 133 may be coupled to any portion of the chassis 102. For example, in a non-limiting example, the drip pan 133 may be coupled to the side faces 108 of the chassis 102, where one or more brackets 136 may position the drip pan 133 above the top face 104 of the chassis 102. In this regard, as shown in FIGS. 6A-6B, the drip pan 133 may be configured to prevent ingress of dripping water from overhead plumbing (e.g., in the hot aisle) when installed within the rack. It is contemplated herein that the drip pan 133 may be removably coupled to the chassis 102 or include a removable portion, such that the drip pan 133 may be emptied easily.

Referring to FIGS. 7A-8, the rPDU system 100 may include a drip shield 132. For example, the drip shield 132 may be arranged above the top face 104 of the chassis 102 and include one or more raised edges 134. The drip shield 132 may be coupled to any portion of the chassis 102. For example, in a non-limiting example, the drip shield 132 may be coupled to the side faces 108 of the chassis 102, where one or more brackets 136 may position the drip shield 132 above the top face 104 of the chassis 102. For instance, the drip shield 132 may be arranged at an angle, such that the drip shield 132 is sloped away from the front of the chassis 102. In this regard, as shown in FIGS. 7A-8, the drip shield 132 may be configured to deflect any moisture away from the chassis 102 to prevent ingress of dripping water from overhead plumbing (e.g., in the hot aisle) when installed within the rack. It is contemplated herein that a pan may be disposed beneath the chassis 102, rack, or the like to capture any deflected moisture.

The rPDU system 100 may include one or more mounting brackets 144 configured to mount the rPDU system 100 within a rack. For example, the mounting brackets 144 may be configured to mount the rPDU system 100 to a beam positioned above the rack via one or more fasteners 146, as shown in FIGS. 6A-6C. For instance, the mounting brackets 144 may couple to a portion of the side face 108 of the chassis 102, where each side face 108 includes one or more mounting brackets 144 configured to couple to a rack mounting bracket 148 to mount the rPDU system 100 to the beam 150. Referring to FIGS. 7A-8, the mounting bracket 144 may run along an edge of the side face 108, where the length of the mounting bracket 144 is substantially similar to the length of the chassis 102.

It is contemplated herein that the mounting bracket may be configured to allow for a safer and simpler procedure of securing the rPDU system 100 to the steel beam, within the data center infrastructure. For example, the bottom side of the rPDU system 100 may be flat and clear of hardware to assist in sliding the chassis 102 into position atop the steel beam. Further, the mounting brackets 144 may be configured to straddle around and below the beam and accurately align with the rPDU system 100 using one or more locating pins on the bracket 144. The bracket 144 may then be secured into the rPDU system 100 with captured hardware/fasteners. Finally, captured screws/fasteners in the bracket 144 are tightened against the bottom side of the beam to secure the bracket/rPDU assembly to the steel beam.

Further, it is contemplated herein that the fasteners 146 may provide constraints in the vertical direction against overturning and horizontal direction against sliding. In some instances, the mounting bracket 144 and/or the rack mounting bracket 148 may include one or more frictional pads (e.g., rubber pads) to increase the frictional coefficient between the respective surfaces (e.g., metal-rubber contact).
Further examples are set out in the clauses below:
1. A rack power distribution unit comprising:
   a chassis formed of a plurality of faces that define a cavity, the plurality of faces including at least a front face, a rear face, one or more side faces, a top face, and a bottom face, wherein the front face includes two or more tiers including at least a first tier positioned proximate to a second tier; and
   one or more over current protection devices coupled to the two or more tiers, wherein the one or more over current protection devices includes at least a first set of the one or more over current protection devices coupled to the first tier and a second set of the one or more over current protection devices coupled to the second tier, wherein the first set of the one or more over current protection devices are arranged at an offset relative to the second set of the one or more over current protection devices.
2. The rack power distribution unit of Clause 1, wherein at least a portion of the top face is arranged on an inclined plane at an angle with respect to an axis perpendicular to the rear face of the chassis.
3. The rack power distribution unit of Clause 2, wherein the angle of the portion of the top face is between 10 and 15 degrees.
4. The rack power distribution unit of Clause 3, wherein the top face includes an additional portion arranged planar, wherein the additional portion is arranged perpendicular to the rear face of the chassis.
5. The rack power distribution unit of any one of the preceding Clauses, wherein at least a portion of the top face is arranged planar.
6. The rack power distribution unit of Clause 5, wherein the top face includes an additional portion arranged perpendicular to the portion of the top face, wherein the additional portion is planar and arranged perpendicular to the rear face of the chassis.
7. The rack power distribution unit of any one of the preceding Clauses, wherein the second tier includes a bottom flange configured to protrude a select distance above the first tier, wherein the bottom flange protrudes substantially perpendicular from an interior of the chassis.
8. The rack power distribution unit of any one of the preceding Clauses, wherein the first tier includes a top flange configured to protrude a select distance away from a front surface of the second tier, wherein the top flange protrudes substantially perpendicular from an interior of the chassis.
9. The rack power distribution unit of Clause 7, wherein the two or more tiers further include a third tier, wherein the third tier includes a third set of the one or more over current protection devices, wherein the third tier includes a bottom flange configured to protrude a select distance above the second tier and the first tier.
10. The rack power distribution unit of any one of the preceding Clauses, wherein the first tier and the second tier are coupled together via one or more fasteners.
11. The rack power distribution unit of any one of the preceding Clauses, wherein the first tier and the second tier are a single, integrated component.
12. The rack power distribution unit of any one of the preceding Clauses, wherein the one or more over current protection devices comprise at least one of:
   one or more circuit breakers or one or more fuses.
13. The rack power distribution unit of any one of the preceding Clauses, wherein the bottom face includes one or more receptacles.
14. The rack power distribution unit of any one of the preceding Clauses, wherein at least one of the rear face or the one or more side faces includes one or more handles.
15. The rack power distribution unit of any one of the preceding Clauses, wherein the top face includes one or more bulkhead connectors and one or more power inlets.
16. The rack power distribution unit of any one of the preceding Clauses, further comprising:
   one or more mounting brackets coupled to a portion the chassis, wherein the one or more mounting brackets are configured to couple to a rack mounting bracket to couple the rack power distribution unit to a beam above a rack.
17. The rack power distribution unit of any one of the preceding Clauses, further comprising:
   a drip shield coupled to a portion of the chassis.
18. The rack power distribution unit of any one of the preceding Clauses, wherein at least one of the first tier or the second tier includes one or more ventilation holes.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

## Claims

1. A rack power distribution unit comprising:
a chassis formed of a plurality of faces that define a cavity, the plurality of faces including at least a front face, a rear face, one or more side faces, a top face, and a bottom face, wherein the front face includes two or more tiers including at least a first tier positioned proximate to a second tier; and
one or more over current protection devices coupled to the two or more tiers, wherein the one or more over current protection devices includes at least a first set of the one or more over current protection devices coupled to the first tier and a second set of the one or more over current protection devices coupled to the second tier.

2. The rack power distribution unit of Claim 1, wherein the first set of the one or more over current protection devices are arranged at an offset relative to the second set of the one or more over current protection devices.

3. The rack power distribution unit of Claim 1 or 2, wherein at least a portion of the top face is arranged on an inclined plane at an angle with respect to an axis perpendicular to the rear face of the chassis.

4. The rack power distribution unit of Claim 3, wherein the angle of the portion of the top face is between 10 and 15 degrees.

5. The rack power distribution unit of Claim 4, wherein the top face includes an additional portion arranged planar, wherein the additional portion is arranged perpendicular to the rear face of the chassis.
5. The rack power distribution unit of any one of the preceding Claims, wherein at least a portion of the top face is arranged planar.

6. The rack power distribution unit of Claim 5, wherein the top face includes an additional portion arranged perpendicular to the portion of the top face, wherein the additional portion is planar and arranged perpendicular to the rear face of the chassis.

7. The rack power distribution unit of any one of the preceding Claims, wherein the second tier includes a bottom flange configured to protrude a select distance above the first tier, wherein the bottom flange protrudes substantially perpendicular from an interior of the chassis.

8. The rack power distribution unit of any one of the preceding Claims, wherein the first tier includes a top flange configured to protrude a select distance away from a front surface of the second tier, wherein the top flange protrudes substantially perpendicular from an interior of the chassis.

9. The rack power distribution unit of Claim 7, wherein the two or more tiers further include a third tier, wherein the third tier includes a third set of the one or more over current protection devices, wherein the third tier includes a bottom flange configured to protrude a select distance above the second tier and the first tier.

10. The rack power distribution unit of any one of the preceding Claims, wherein the first tier and the second tier are coupled together via one or more fasteners.

11. The rack power distribution unit of any one of the preceding Claims, wherein the first tier and the second tier are a single, integrated component.

12. The rack power distribution unit of any one of the preceding Claims, wherein the one or more over current protection devices comprise at least one of:
one or more circuit breakers or one or more fuses.

13. The rack power distribution unit of any one of the preceding Claims, wherein the bottom face includes one or more receptacles.

14. The rack power distribution unit of any one of the preceding Claims, wherein at least one of the rear face or the one or more side faces includes one or more handles.

15. The rack power distribution unit of any one of the preceding Claims, wherein the top face includes one or more bulkhead connectors and one or more power inlets; or optionally further comprising:
one or more mounting brackets coupled to a portion the chassis, wherein the one or more mounting brackets are configured to couple to a rack mounting bracket to couple the rack power distribution unit to a beam above a rack; or optionally further comprising:
a drip shield coupled to a portion of the chassis; or optionally
wherein at least one of the first tier or the second tier includes one or more ventilation holes.
